# EUROPEAN PATENT APPLICATION

(11) **EP 4 604 689 A1**
(43) Date of publication of application: **20.08.2025**
(21) Application number: 25152271.0
(22) Date of filing: 16.01.2025
(51) Int. Cl.: H10D 30/66, H10D 62/10, H10D 64/27

(54) **POWER SEMICONDUCTOR DEVICE INCLUDING GATE STRUCTURE WITH IMPROVED RELIABILITY**

(30) Priority: 13.02.2024 KR 20240020546
(71) Applicant: Hyundai Mobis Co., Ltd., Gangnam-gu Seoul 06141 (KR)
(72) Inventor: LEE, Ju Hwan, 16891 Yongin-si (KR); WOO, Hyuk, 16891 Yongin-si (KR); KANG, Min Gi, 16891 Yongin-si (KR); HA, Jeong Mok, 16891 Yongin-si (KR); KIM, Tae Yang, 16891 Yongin-si (KR); KIM, Sin A, 16891 Yongin-si (KR); HWANG, Jun Ha, 16891 Yongin-si (KR)
(74) Representative: Vossius & Partner Patentanwälte Rechtsanwälte mbB

(57) **Abstract**

A power semiconductor device including a semiconductor substrate having a trench defined within an upper surface of the semiconductor substrate, the trench being aligned along and extending in a first direction, a first gate electrode layer disposed inside the trench and configured to extend in a second direction along the upper surface of the semiconductor substrate outside the trench, a second gate electrode layer disposed inside the trench, configured to extend in the second direction along the upper surface of the semiconductor substrate outside the trench, and spaced apart from the first gate electrode layer in the first direction, and an intermediate insulating layer disposed inside the trench, configured to extend in the second direction along the upper surface of the semiconductor substrate outside the trench, and disposed between the first gate electrode layer and the second gate electrode layer.

## Description

### CROSS-REFERENCE TO RELATED APPLICATION

This application claims the benefit of Korean Patent Application No. 10-2024-0020546, filed in the Korean Intellectual Property Office on February 13, 2024.

### 1. Field

The present disclosure relates to a power semiconductor device and, more particularly, to a power semiconductor device including a gate with improved reliability.

### 2. Description of the Related Art

A power semiconductor device is a semiconductor device that operates in a high-voltage and high-current environment. The power semiconductor device may be used in a field requiring high power switching, such as an inverter. Examples of transistors that may be used as the power semiconductor device include an insulated gate bipolar transistor (IGBT) and a power metal-oxide semiconductor field effect transistor (MOSFET), etc.

The power semiconductor device may include a gate, and the gate may include an insulating layer. The power semiconductor device may operate when a voltage greater than a threshold voltage is applied to the gate, and may not operate when a voltage less than the threshold voltage is applied to the gate. Research is actively being conducted to improve the reliability of the operation of the power semiconductor device.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In a general aspect, here is provided a power semiconductor device including a semiconductor substrate having a trench defined within an upper surface of the semiconductor substrate, the trench being aligned along and extending in a first direction, a first gate electrode layer disposed inside the trench and configured to extend in a second direction along the upper surface of the semiconductor substrate outside the trench, a second gate electrode layer disposed inside the trench, configured to extend in the second direction along the upper surface of the semiconductor substrate outside the trench, and spaced apart from the first gate electrode layer in the first direction, and an intermediate insulating layer disposed inside the trench, configured to extend in the second direction along the upper surface of the semiconductor substrate outside the trench, and disposed between the first gate electrode layer and the second gate electrode layer.

The power semiconductor device may include a top insulating layer disposed on the first gate electrode layer, the second gate electrode layer, and the intermediate insulating layer.

The top insulating layer may be configured to extend to contact the upper surface of the sem iconductor substrate, and is further configured to contact respective side surfaces of each of the first gate electrode layer and the second gate electrode layer.

The power semiconductor device may include a bottom insulating layer disposed along an inner wall of the trench.

The bottom insulating layer may be configured to extend over the upper surface of the semiconductor substrate and the top insulating layer may be configured to contact the bottom insulating layer on the upper surface of the semiconductor substrate.

The power semiconductor device may include a source electrode layer disposed on the top insulating layer and configured to contact a side surface of the top insulating layer and a drain electrode layer disposed under a lower surface of the semiconductor substrate, the drain electrode layer being configured to face the upper surface of the semiconductor substrate.

The first gate electrode layer may include one or more of poly-silicon, metal, metal nitride, and metal silicide, the second gate electrode layer may include one or more of poly-silicon, metal, metal nitride, and metal silicide, and the intermediate insulating layer may include one or more of silicon oxide, silicon nitride, germanium oxide, germanium nitride, hafnium oxide, zirconium oxide, and aluminum oxide.

The power semiconductor device may include a source region disposed in the first direction from the trench inside the semiconductor substrate, the source region including an impurity of a first conductive type and a body region configured to contact a lower surface of the source region and, the body region including an impurity of a second conductive type, the second conductive type being opposite of the first conductive type.

In a general aspect, here is provided a power semiconductor device including planar gate electrode layers configured to be spaced apart from each other in a first direction and being provided on an upper surface of a semiconductor substrate and configured to extend in a second direction, trench gate electrode layers configured to contact lower surfaces of the planar gate electrode layers, respectively, spaced apart from each other in the first direction, and recessed into the semiconductor substrate in a third direction, and an intermediate insulating layer disposed between the planar gate electrode layers on the upper surface of the semiconductor substrate, recessed in the third direction inside the semiconductor substrate, and disposed between the trench gate electrode layers.

First widths of each of the planar gate electrode layers in the first direction may be larger than second widths of each of the trench gate electrode layers in the first direction.

The power semiconductor device may include a top insulating layer disposed on the planar gate electrode layers and the intermediate insulating layer and may be configured to contact the intermediate insulating layer.

The top insulating layer may be configured to extend to contact the upper surface of the semiconductor substrate and to contact respective side surfaces of each of the planar gate electrode layers.

The power semiconductor device may include a bottom insulating layer disposed under the trench gate electrode layers and the intermediate insulating layer and may be configured to contact the intermediate insulating layer.

The bottom insulating layer may be configured to extend along respective side surfaces of each of the trench gate electrode layers.

The bottom insulating layer may be configured to extend over the upper surface of the semiconductor substrate, and the top insulating layer may be configured to contact the bottom insulating layer on the upper surface of the semiconductor substrate.

The power semiconductor device may include a source electrode layer disposed on the top insulating layer and configured to contact a side surface of the top insulating layer and a drain electrode layer disposed under a lower surface of the semiconductor substrate and configured to face the upper surface of the semiconductor substrate.

Each of the planar gate electrode layers and the trench gate electrode layers may respectively include one or more of poly-silicon, metal, metal nitride, and metal silicide, and the intermediate insulating layer may include one or more of silicon oxide, silicon nitride, germanium oxide, germanium nitride, hafnium oxide, zirconium oxide, and aluminum oxide.

The power semiconductor device may include a source region disposed inside the semiconductor substrate, configured to overlap each of the planar gate electrode layers, and including an impurity of a first conductive type and a body region configured to contact a lower surface of the source region and including an including an impurity of a second conductive type, the second conductive type being opposite to the first conductive type.

### BRIEF DESCRIPTION OF THE DRAWINGS

The above and other objects, features and advantages of the present disclosure will be more apparent from the following detailed description taken in conjunction with the accompanying drawings:
FIG. 1 is a perspective view illustrating a portion of a power semiconductor device according to an embodiment of the present disclosure;
FIG. 2 is a perspective view illustrating a gate electrode layer and an intermediate insulating layer of the power semiconductor device of FIG. 1;
FIG. 3 is a cross-sectional view illustrating a surface taken along line A-A' of the power semiconductor device of FIG. 1;
FIG. 4 is a cross-sectional view illustrating a surface taken along line B-B' of a first cross-section of FIG. 3;
FIG. 5 is a cross-sectional view illustrating a surface taken along line C-C' of the first cross-section of FIG. 3;
FIG. 6 is a cross-sectional view illustrating a surface taken along line D-D' of the first cross-section of FIG. 3; and
FIG. 7 is a cross-sectional view illustrating a surface taken along line E-E' of the first cross-section of FIG. 3.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is completely disclosed, and a person with ordinary skill in the art can fully understand the scope of the present disclosure. The present disclosure will be defined only by the scope of the appended claims. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

In a description of the embodiment, in a case in which any one element is described as being formed on or under another element, such a description includes both a case in which the two elements are formed in direct contact with each other and a case in which the two elements are in indirect contact with each other with one or more other elements interposed between the two elements. In addition, when one element is described as being formed on or under another element, such a description may include a case in which the one element is formed at an upper side or a lower side with respect to another element.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof..

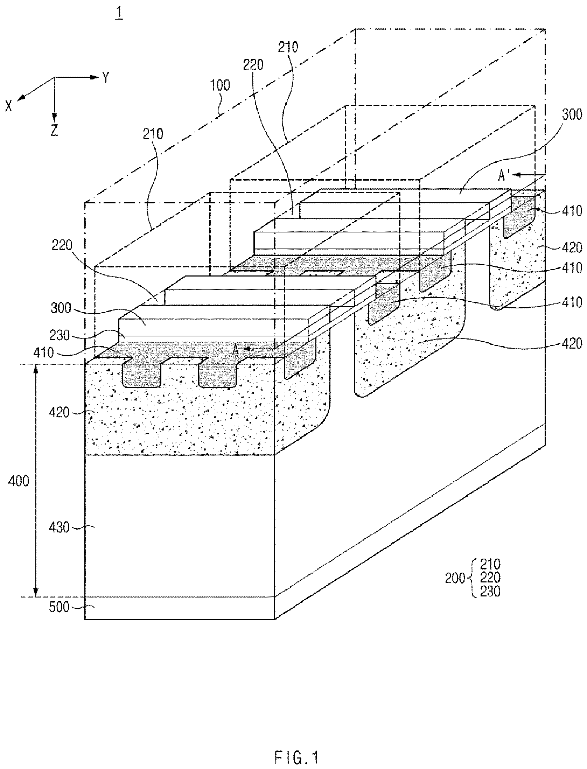

FIG. 1 is a perspective view illustrating a portion of a power semiconductor device according to an embodiment of the present disclosure.

Referring to FIG. 1, a power semiconductor device 1 may include a source electrode layer 100, a gate insulating layer 200, a gate electrode layer 300, a semiconductor substrate 400, and a drain electrode layer 500.

The source electrode layer 100 may be disposed on the gate insulating layer 200. The source electrode layer 100 may be a region to which a source voltage is applied. The source electrode layer 100 may include a conductive material, for example, at least one of poly-silicon, doped poly-silicon, metal, metal nitride, metal silicide, or combination thereof. The source voltage applied to the source electrode layer 100 may be applied to a source region 410.

The gate insulating layer 200 may include a top insulating layer 210, an intermediate insulating layer 220, and a bottom insulating layer 230. The top insulating layer 210 may be disposed on the intermediate insulating layer 220. The intermediate insulating layer 220 may be disposed on the bottom insulating layer 230. Each of the top insulating layer 210, the intermediate insulating layer 220, and the bottom insulating layer 230 may include an insulating material, for example, at least one of silicon oxide, silicon nitride, germanium oxide, germanium nitride, hafnium oxide, zirconium oxide, aluminum oxide, and a combination thereof. Each of the top insulating layer 210, the intermediate insulating layer 220, and the bottom insulating layer 230 may be composed of the same material.

The top insulating layer 210 may electrically separate the source electrode layer 100 from the gate electrode layer 300. The intermediate insulating layer 220 may reduce stress that may occur inside the gate electrode layer 300. The bottom insulating layer 230 may electrically separate the gate electrode layer 300 from the semiconductor substrate 400.

The gate electrode layer 300 may be a region to which a gate voltage is applied. When difference between the gate voltage and the source voltage is greater than or equal to a threshold voltage of the power semiconductor device 1, the power semiconductor device 1 may be in an on-state. When the difference between the gate voltage and the source voltage is less than the threshold voltage of the power semiconductor device 1, the power semiconductor device 1 may be in an off-state. When the power semiconductor device 1 is in the on-state, unlike the off-state, a current flows inside the semiconductor substrate 400 and the power semiconductor device 1 may operate.

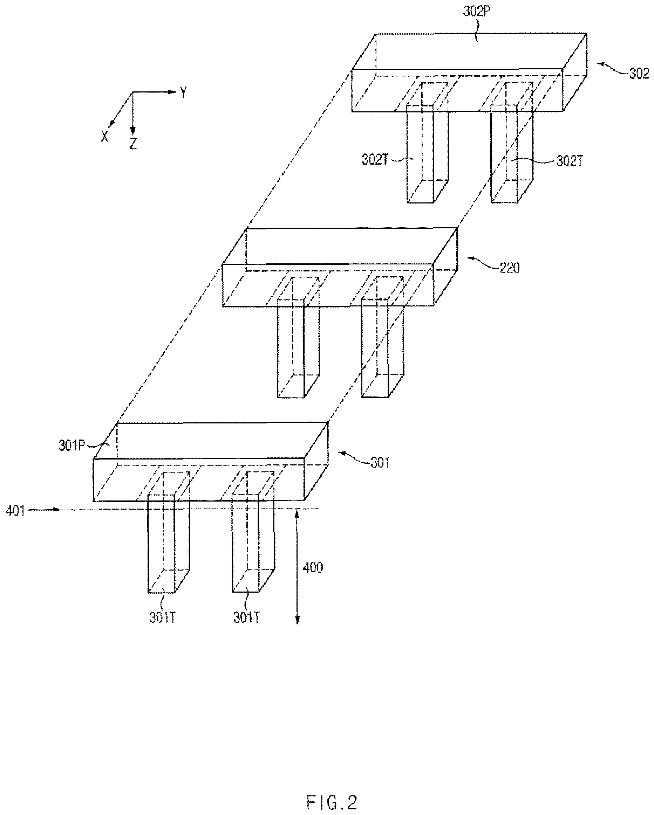

The gate electrode layer 300 may include a conductive material, for example, at least one of poly-silicon, doped poly-silicon, metal, metal nitride, metal silicide, or a combination thereof. A more detailed description of the structure of the gate electrode layer 300 will be made with reference to FIG. 2.

The semiconductor substrate 400 may include the source region 410, a body region 420, and a drift region 430. The semiconductor substrate 400 may include a material having a larger band gap (e.g., silicon carbide (SiC), gallium nitride (GaN), etc.) than silicon.

The source region 410 may be a region including an impurity of a first conductive type (e.g., an N type). The source region 410 may be a region in contact with the source electrode layer 100 and to which a source voltage is applied by the source electrode layer 100. The source region 410 may be disposed on the upper part of the semiconductor substrate 400.

The body region 420 may be a region including an impurity of a second conductive type (e.g., a P type) opposite to the first conductive type. The body region 420 may be in contact with the side surface and lower surface of the source region 410. The body region 420 may form a channel that allows a current to flow between the drift region 430 and the source region 410 when the power semiconductor device 1 is in the on-state. The channel may be formed, for example, in a vertical direction "Z".

The drift region 430 may be a region including a first conductive type impurity. The concentration of the first conductive type impurity in the drift region 430 may be lower than the concentration of the first conductive type impurity in the source region 410.

The drain electrode layer 500 may be disposed under the semiconductor substrate 400. The drain electrode layer 500 may be a region to which a drain voltage (e.g., a ground voltage) is applied. The drain electrode layer 500 may include a conductive material, for example, at least one of poly-silicon, doped poly-silicon, metal, metal nitride, metal silicide, or a combination thereof.

FIG. 2 is a perspective view illustrating the gate electrode layer 300 and the intermediate insulating layer 220 of the power semiconductor device 1 of FIG. 1.

Referring to FIGS. 1 and 2, a first gate electrode layer 301 and a second gate electrode layer 302 in FIG. 2 may be substantially identical to a pair of gate electrode layers 300 adjacent to each other in FIG. 1. For convenience of explanation, reference numerals of the gate electrode layers 300 in FIG. 1 and the first and second gate electrode layers 301 and 302 in FIG. 2 are illustrated to be different.

The first gate electrode layer 301 may include first trench gate electrode layers 301T and first planar gate electrode layers 301P. The first gate electrode layer 301 may include at least one of poly-silicon, poly-silicon including impurities, metal, metal nitride, metal silicide, or a combination thereof.

The first gate electrode layer 301 may be disposed inside a predetermined trench and may extend in a second direction "Y" along an upper surface 401 of the semiconductor substrate 400 outside a first trench T1.

Each of the first trench gate electrode layers 301T may be recessed into the semiconductor substrate 400 (for example, may extend in a third direction "Z"). The first trench gate electrode layer 301T may include at least one first trench gate electrode layer 301T. For example, when the first trench gate electrode layer 301T includes a plurality of first trench gate electrode layers 301T, the first trench gate electrode layers 301T may be spaced apart from each other at a predetermined interval along the second direction "Y". The first trench gate electrode layers 301T may be in contact with the lower surfaces of the first planar gate electrode layers 301P, respectively, may be spaced apart from each other along a first direction "X", and may be recessed into the semiconductor substrate 400 along the third direction "Z".

Each of the first planar gate electrode layers 301P may be in contact with the top of the first trench gate electrode layer 301T and, for example, may extend along the second direction "Y". The first planar gate electrode layer 301P may be disposed on the upper surface 401 of the semiconductor substrate 400. The first planar gate electrode layers 301P may be spaced apart from each other along the first direction "X".

The second gate electrode layer 302 may include a second trench gate electrode layer 302T and a second planar gate electrode layer 302P. The second gate electrode layer 302 may include a material identical to a material of the first gate electrode layer 301, for example, at least one of poly-silicon, poly-silicon including impurities, metal, metal nitride, metal silicide, or a combination thereof.

The second gate electrode layer 302 may be disposed inside a predetermined trench, may extend in the second direction "Y" along the upper surface 401 of the semiconductor substrate 400 outside the trench, and may be spaced apart from the first gate electrode layer 301 in the first direction "X".

The second gate electrode layer 302 may be spaced apart from the first gate electrode layer 301 in the first direction "X". When viewed in the first direction "X", the second gate electrode layer 302 may overlap or be aligned with the first gate electrode layer 301.

The second trench gate electrode layer 302T may be recessed into the semiconductor substrate 400 (for example, may extend in the third direction "Z"). The second trench gate electrode layer 302T may include at least one second trench gate electrode layer 302T. For example, when the second trench gate electrode layer 302T includes a plurality of second trench gate electrode layers 302T, the second trench gate electrode layers 302T may be spaced apart from each other at a predetermined interval in the second direction "Y".

The second trench gate electrode layers 302T may overlap or be aligned with the first trench gate electrode layers 301T in the first direction "X". The second trench gate electrode layer 302T may be spaced apart from the first trench gate electrode layer 301T in the first direction "X".

The second planar gate electrode layer 302P may be in contact with the top of the second trench gate electrode layer 302T and, for example, may extend in the second direction "Y". The second planar gate electrode layer 302P may be disposed on the upper surface 401 of the semiconductor substrate 400. The second planar gate electrode layer 302P may be spaced apart from the first planar gate electrode layer 301P in the first direction "X". When viewed in the first direction "X", the second planar gate electrode layer 302P may overlap or be aligned with the first planar gate electrode layer 301P.

The first gate electrode layer 301 and the second gate electrode layer 302 may be, for example, a pair of gate electrode layers 300 having corresponding shapes and spaced apart from each other in the first direction "X".

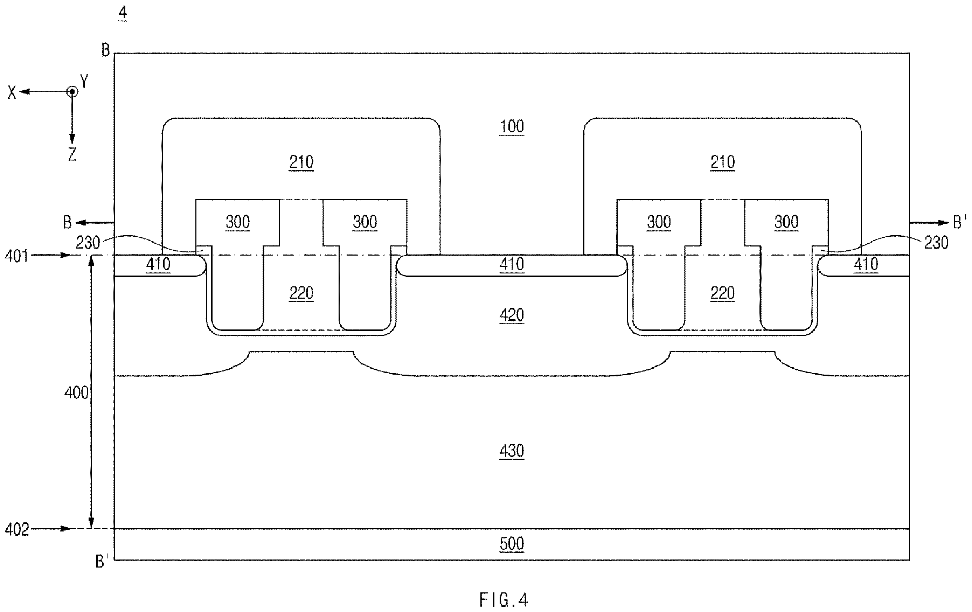

Each of the first trench gate electrode layer 301T and the second trench gate electrode layer 302T may have, for example, a rectangular parallelepiped shape, but is not limited thereto. For example, each of the first trench gate electrode layer 301T and the second trench gate electrode layer 302T may have rounded shapes at corners or vertices. When an electric field is concentrated around each of the first trench gate electrode layer 301T and the second trench gate electrode layer 302T, insulation breakdown of the bottom insulating layer 230 (see FIG. 4) disposed under each of the first trench gate electrode layer 301T and the second trench gate electrode layer 302T may occur, thereby resulting in destruction of the power semiconductor device 1. When the corners or vertices of each of the first trench gate electrode layer 301T and the second trench gate electrode layer 302T within the semiconductor substrate 400 have rounded shapes, the electric field concentrated around each of the first trench gate electrode layer 301T and the second trench gate electrode layer 302T within the semiconductor substrate 400 may be alleviated, and destruction of the power semiconductor device 1 may be prevented.

According to an embodiment, the width of each of the first or second planar gate electrode layers 301P or 302P in the first direction "X" may be larger than the width of each of the first or second trench gate electrode layers 301T or 302T in the first direction "X".

The intermediate insulating layer 220 may be disposed between the first gate electrode layer 301 and the second gate electrode layer 302. For example, at least a portion of the intermediate insulating layer 220 may be recessed into the semiconductor substrate 400 and may be disposed between the first trench gate electrode layer 301T and the second trench gate electrode layer 302T. Another portion of the intermediate insulating layer 220 may be disposed between the first planar gate electrode layer 301P and the second planar gate electrode layer 302P on the upper surface 401 of the semiconductor substrate 400.

According to an embodiment, the intermediate insulating layer 220 may have a shape corresponding to the first gate electrode layer 301 and the second gate electrode layer 302.

The intermediate insulating layer 220 may be arranged between the first and second gate electrode layers 301 and 302 to relieve stress within a pair of the gate electrode layers 300 and improve gate reliability of the power semiconductor device 1.

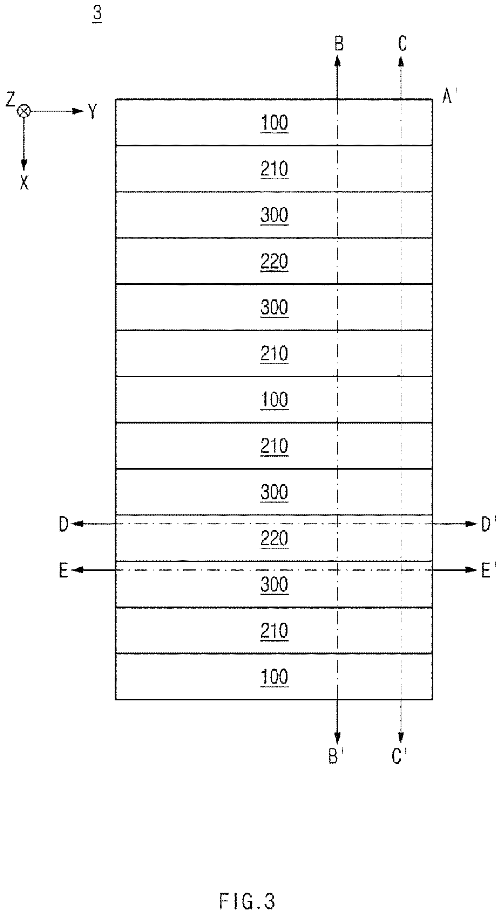

FIG. 3 is a cross-sectional view illustrating a surface taken along line A-A' of the power semiconductor device 1 of FIG. 1.

Referring to FIGS. 1 and 3, a first cross-section 3 may be an embodiment of a cross-section taken along line A-A' of the power semiconductor device 1. The first cross-section 3 may include the source electrode layer 100, the top insulating layer 210, the intermediate insulating layer 220, the first gate electrode layer 301, and the second gate electrode layer 302. Any description that overlaps the description of FIGS. 1 and 2 will be omitted.

A surface on which the source electrode layer 100 and the top insulating layer 210 are in contact with each other may be a side surface of the top insulating layer 210.

A surface on which the top insulating layer 210 and the first gate electrode layer 301 are in contact with each other may be a side surface of the first planar gate electrode layer 301P.

A surface on which the top insulating layer 210 and the second gate electrode layer 302 are in contact with each other may be a side surface of the second planar gate electrode layer 302P.

The intermediate insulating layer 220 may be disposed between the first gate electrode layer 301 and the second gate electrode layer 302. The first gate electrode layer 301 illustrated in FIG. 3 may be a region corresponding to the first planar gate electrode layer 301P in FIG. 2. The second gate electrode layer 302 illustrated in FIG. 3 may be a region corresponding to the second planar gate electrode layer 302P in FIG. 2. A first side surface of the intermediate insulating layer 220 may be in contact with the first gate electrode layer 301, and a second side surface of the intermediate insulating layer 220 may be in contact with the second gate electrode layer 302.

When a strong electric field or current occurs inside the power semiconductor device 1, stress may occur at the center of the gate electrode layer 300. When stress occurs in the gate electrode layer 300, the performance of the gate electrode layer 300 may deteriorate and the reliability of the gate of the power semiconductor device 1 may deteriorate.

When the intermediate insulating layer 220 is disposed at the center of the gate electrode layer 300, the stress at the center is distributed, which reduces performance degradation of the gate electrode layer 300 and improves the reliability of the power semiconductor device 1.

In FIGS. 4 to 7 below, contents that overlap contents described in FIGS. 1 to 3 will be omitted.

FIG. 4 is a cross-sectional view illustrating a surface taken along line B-B' of the first cross-section 3 of FIG. 3.

Referring to FIGS. 1 to 4, a second cross-section 4 may be an embodiment of a cross-section taken along line B-B' of the first cross-section 3. The second cross-section 4 may include the source electrode layer 100, the top insulating layer 210, the intermediate insulating layer 220, the bottom insulating layer 230, the first gate electrode layer 301, the second gate electrode layer 302, the semiconductor substrate 400, and the drain electrode layer 500.

The source electrode layer 100 may be disposed on the top insulating layer 210. For example, the source electrode layer 100 may be in contact with the upper surface of the top insulating layer 210. The source electrode layer 100 may extend in the second direction "Y". The source electrode layer 100 may further extend along the third direction "Z" into space between two adjacent top insulating layers 210. For example, the source electrode layer 100 may be in contact with one side surface of the top insulating layer 210. The source electrode layer 100 may be in contact with the upper surface 401 of the semiconductor substrate 400 and may be in contact with the source region 410.

The top insulating layer 210 may be disposed on the first gate electrode layer 301. For example, the top insulating layer 210 may be in contact with the upper surface of the first gate electrode layer 301. The top insulating layer 210 may be in contact with the side surface of the first gate electrode layer 301.

The top insulating layer 210 may be disposed even on the second gate electrode layer 302. For example, the top insulating layer 210 may be in contact with the upper surface of the second gate electrode layer 302. The top insulating layer 210 may be in contact with the side surface of the second gate electrode layer 302.

The top insulating layer 210 may be disposed even on the intermediate insulating layer 220. For example, the top insulating layer 210 may be in contact with the upper surface of the intermediate insulating layer 220.

The first gate electrode layer 301 and the second gate electrode layer 302 may each be surrounded by the top insulating layer 210, the intermediate insulating layer 220, and the bottom insulating layer 230.

The intermediate insulating layer 220 may be disposed between the first gate electrode layer 301 and the second gate electrode layer 302. The intermediate insulating layer 220 may be disposed between the top insulating layer 210 and the bottom insulating layer 230. For example, the intermediate insulating layer 220 may be surrounded by the first gate electrode layer 301, the second gate electrode layer 302, the top insulating layer 210, and the bottom insulating layer 230.

The bottom insulating layer 230 may be disposed along the inner wall of the first trench T1 that is recessed into the semiconductor substrate 400 from the upper surface 401 of the semiconductor substrate 400. In the power semiconductor device 1, the bottom insulating layer 230 may include at least one bottom insulating layer. In an embodiment in which the bottom insulating layer 230 includes at least two bottom insulating layers, the bottom insulating layer 230 may be recessed into the semiconductor substrate 400 from the upper surface 401 of the semiconductor substrate 400, and another bottom insulating layer 230 may be disposed along the inner wall of a second trench T2 spaced apart from the first trench T1 in the first direction "X".

The semiconductor substrate 400 may include the source region 410, the body region 420, and the drift region 430.

The source region 410 may be disposed between the first trench T1 and the second trench T2. The source region 410 may be spaced apart from or in contact with at least one of the first trench T1 and the second trench T2. FIG. 4 illustrates an embodiment in which the source region 410 is in contact with the first trench T1 and the second trench T2. The source region 410 may be disposed on the upper surface 401 of the semiconductor substrate 400. The side surface of the source region 410 may be in contact with the bottom insulating layer 230. The upper surface of the source region 410 may be in contact with the top insulating layer 210 and the source electrode layer 100.

The body region 420 may be disposed under the source region 410 and the bottom insulating layer 230. For example, the body region 420 may be in contact with the lower surface and/or the side surface of the source region 410. The body region 420 may be in contact with the lower surface and the side surface of the bottom insulating layer 230. The body region 420 may be formed to be deep under the source region 410 than under the bottom insulating layer 230.

The drift region 430 may be disposed under the body region 420. For example, the drift region 430 may be in contact with the lower surface of the body region 420.

The drain electrode layer 500 may be disposed under the drift region 430. For example, the drain electrode layer 500 may be in contact with the lower surface of the drift region 430. The lower surface of the drift region 430 may be, for example, a lower surface 402 of the semiconductor substrate 400.

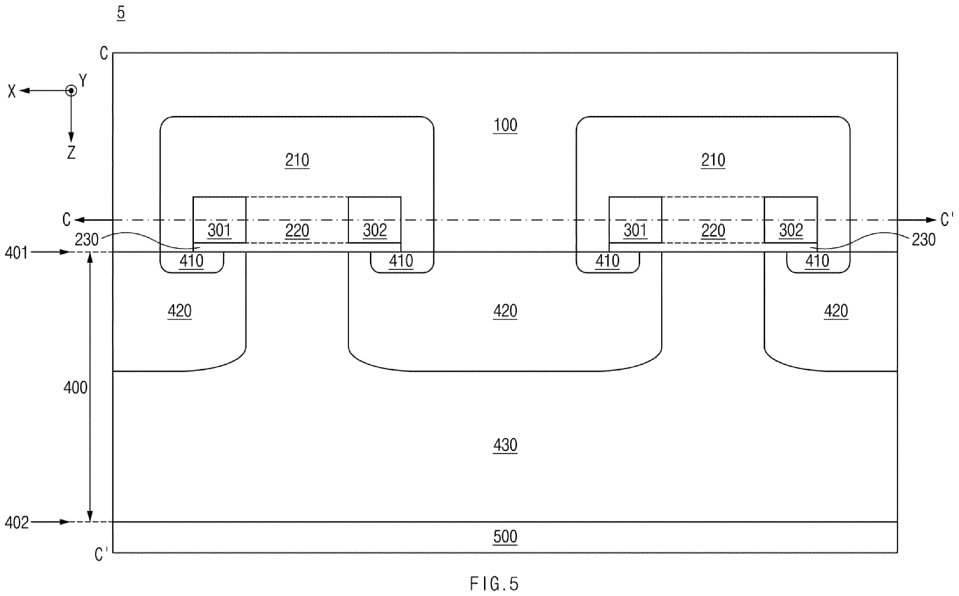

FIG. 5 is a cross-sectional view illustrating a surface taken along line C-C' of the first cross-section 3 of FIG. 3.

Referring to FIGS. 1, 2, 3, and 5, a third cross-section 5 may be an embodiment of a cross-section taken along line C-C' of the first cross-section 3. The third cross-section 5 may include the source electrode layer 100, the top insulating layer 210, the intermediate insulating layer 220, the bottom insulating layer 230, the first gate electrode layer 301, the second gate electrode layer 302, the source region 410, the body region 420, the drift region 430, and the drain electrode layer 500.

The intermediate insulating layer 220 may be disposed between the top insulating layer 210 and the bottom insulating layer 230. For example, the intermediate insulating layer 220 may be in contact with the lower surface of the top insulating layer 210, and may be in contact with the upper surface of the bottom insulating layer 230.

Each of the first and second gate electrode layers 301 and 302 may be surrounded by the top insulating layer 210, the intermediate insulating layer 220, and the bottom insulating layer 230. For example, the upper surface of the first gate electrode layer 301 may be in contact with the top insulating layer 210. A first side surface of the first gate electrode layer 301 may be in contact with the intermediate insulating layer 220, and a second side surface thereof may be in contact with the top insulating layer 210. The lower surface of the first gate electrode layer 301 may be in contact with the bottom insulating layer 230.

The source region 410 may be in contact with the top insulating layer 210 and the bottom insulating layer 230. The source region 410 may overlap the second gate electrode layer 302 when viewed in the third direction "Z".

The drift region 430 may include a vertical region of the drift region 430 in contact with the upper surface 401 of the semiconductor substrate 400 in at least a portion of a region in which the drift region 430 overlaps the intermediate insulating layer 220 when the drift region 430 is viewed in the third direction "Z". The vertical region may be in contact with the side surface of the body region 420.

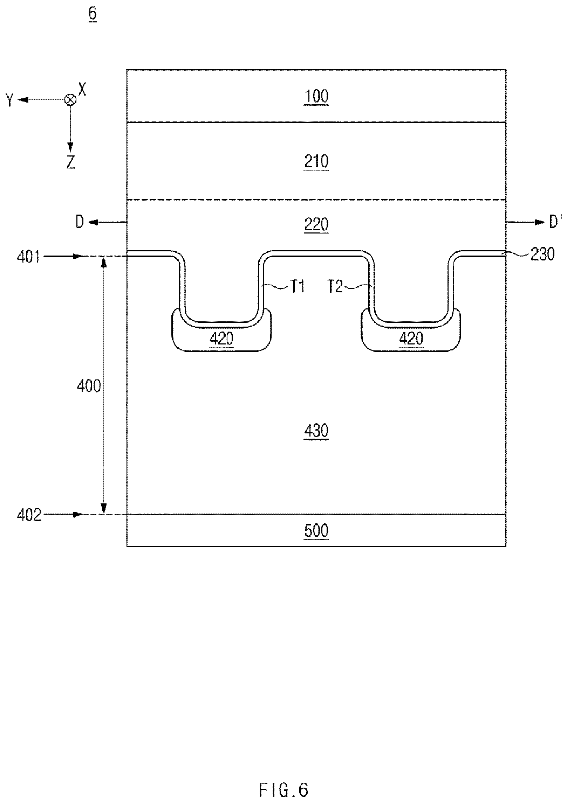

FIG. 6 is a cross-sectional view illustrating a surface taken along line D-D' of the first cross-section 3 of FIG. 3.

Referring to FIGS. 1, 2, 3, and 6, a fourth cross-section 6 may be an embodiment of a cross-section taken along line D-D' of the first cross-section 3. The fourth cross-section 6 may include the source electrode layer 100, the top insulating layer 210, the intermediate insulating layer 220, the bottom insulating layer 230, the semiconductor substrate 400, and the drain electrode layer 500.

The source electrode layer 100 may be disposed on the top insulating layer 210. For example, the source electrode layer 100 may be in contact with the upper surface of the top insulating layer 210. The top insulating layer 210 may be disposed on the intermediate insulating layer 220. For example, the top insulating layer 210 may be in contact with the upper surface of the intermediate insulating layer 220.

The semiconductor substrate 400 may include one or more trenches. For example, the semiconductor substrate 400 may include the first trench T1 recessed into the semiconductor substrate 400 from the upper surface 401 of the semiconductor substrate 400, and the second trench T2 that is recessed into the semiconductor substrate 400 from the upper surface 401 of the semiconductor substrate 400 and is spaced apart from the first trench T1 in the second direction "Y". The semiconductor substrate 400 may include the body region 420 and the drift region 430.

The bottom insulating layer 230 may be disposed along the upper surface 401 of the semiconductor substrate 400. The bottom insulating layer 230 may be disposed along the inner wall of the first trench T1. The bottom insulating layer 230 may be disposed along the inner wall of the second trench T2.

The body region 420 may be disposed under the first trench T1. For example, the body region 420 may be in contact with the bottom insulating layer 230 disposed on the inner wall of the first trench T1. The body region 420 may be disposed under the second trench T2. For example, the body region 420 may be in contact with the bottom insulating layer 230 disposed on the inner wall of the second trench T2.

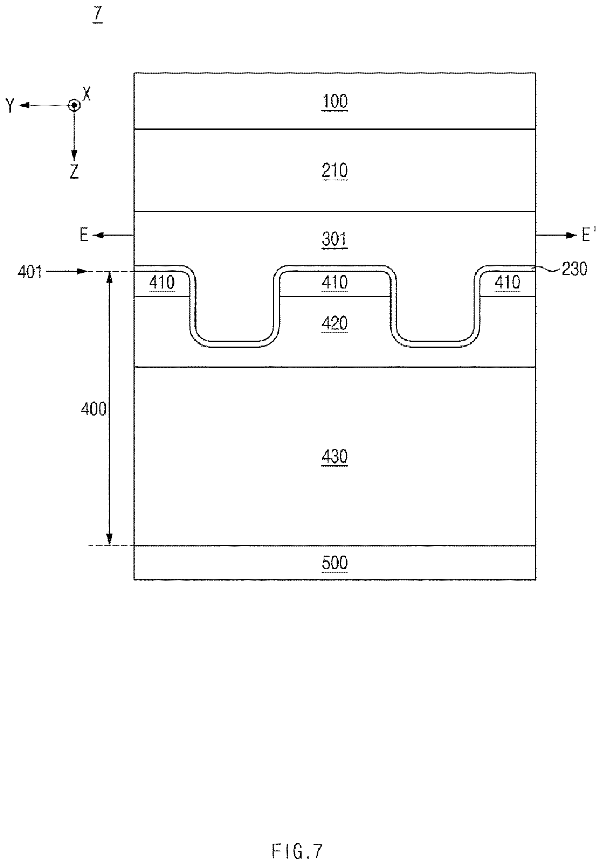

FIG. 7 is a cross-sectional view illustrating a surface taken along line E-E' of the first cross-section 3 of FIG. 3.

Referring to FIGS. 1, 2, 3, and 7, a fifth cross-section 7 may be an embodiment of a cross-section taken along line E-E' of the first cross-section 3. The fifth cross-section 7 may include the source electrode layer 100, the top insulating layer 210, the bottom insulating layer 230, the first gate electrode layer 301, the semiconductor substrate 400, and the drain electrode layer 500.

The top insulating layer 210 may be disposed on the first gate electrode layer 301. For example, the top insulating layer 210 may be in contact with the upper surface of the first gate electrode layer 301.

The bottom insulating layer 230 may be disposed along the upper surface 401 of the semiconductor substrate 400. The bottom insulating layer 230 may be disposed along the inner wall of the first trench T1. The bottom insulating layer 230 may be disposed along the inner wall of the second trench T2.

The semiconductor substrate 400 may include the source region 410, the body region 420, and the drift region 430.

The source region 410 may be in contact with the bottom insulating layer 230 at the upper surface 401 of the semiconductor substrate 400. The source region 410 may be disposed between the first trench T1 and the second trench T2.

The body region 420 may be disposed under the source region 410. For example, the body region 420 may be in contact with the lower surface of the source region 410. The body region 420 may be disposed even under the first trench T1 and the second trench T2.

According to an embodiment of the present disclosure, the power semiconductor device may have improved gate reliability.

Various embodiments of the present disclosure do not list all available combinations but are for describing a representative aspect of the present disclosure, and descriptions of various embodiments may be applied independently or may be applied through a combination of two or more.

A number of embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A power semiconductor device, comprising:
a semiconductor substrate having a trench defined within an upper surface of the semiconductor substrate, the trench being aligned along and extending in a first direction;
a first gate electrode layer disposed inside the trench and configured to extend in a second direction along the upper surface of the semiconductor substrate outside the trench;
a second gate electrode layer disposed inside the trench, configured to extend in the second direction along the upper surface of the semiconductor substrate outside the trench, and spaced apart from the first gate electrode layer in the first direction; and
an intermediate insulating layer disposed inside the trench, configured to extend in the second direction along the upper surface of the semiconductor substrate outside the trench, and disposed between the first gate electrode layer and the second gate electrode layer.

2. The power semiconductor device of claim 1, further comprising:
a top insulating layer disposed on the first gate electrode layer, the second gate electrode layer, and the intermediate insulating layer.

3. The power semiconductor device of claim 2, wherein the top insulating layer is configured to extend to contact the upper surface of the semiconductor substrate, and is further configured to contact respective side surfaces of each of the first gate electrode layer and the second gate electrode layer.

4. The power semiconductor device of claim 2, or 3, further comprising:
a bottom insulating layer disposed along an inner wall of the trench.

5. The power semiconductor device of claim 4, wherein the bottom insulating layer is configured to extend over the upper surface of the semiconductor substrate, and
wherein the top insulating layer is configured to contact the bottom insulating layer on the upper surface of the semiconductor substrate.

6. The power semiconductor device of any one of claims 2 to 5, further comprising:
a source electrode layer disposed on the top insulating layer and configured to contact a side surface of the top insulating layer; and
a drain electrode layer disposed under a lower surface of the semiconductor substrate, the drain electrode layer being configured to face the upper surface of the semiconductor substrate.

7. The power semiconductor device of any one of claims 1 to 6, further comprising:
a source region disposed in the first direction from the trench inside the semiconductor substrate, the source region comprising an impurity of a first conductive type; and
a body region configured to contact a lower surface of the source region and, the body region comprising an impurity of a second conductive type, the second conductive type being opposite of the first conductive type.

8. A power semiconductor device, comprising:
planar gate electrode layers configured to be spaced apart from each other in a first direction and being provided on an upper surface of a semiconductor substrate and configured to extend in a second direction;
trench gate electrode layers configured to contact lower surfaces of the planar gate electrode layers, respectively, spaced apart from each other in the first direction, and recessed into the semiconductor substrate in a third direction; and
an intermediate insulating layer disposed between the planar gate electrode layers on the upper surface of the semiconductor substrate, recessed in the third direction inside the semiconductor substrate, and disposed between the trench gate electrode layers.

9. The power semiconductor device of claim 8, wherein first widths of each of the planar gate electrode layers in the first direction is larger than second widths of each of the trench gate electrode layers in the first direction.

10. The power semiconductor device of claim 8, or 9, further comprising:
a top insulating layer disposed on the planar gate electrode layers and the intermediate insulating layer and configured to contact the intermediate insulating layer.

11. The power semiconductor device of claim 10, wherein the top insulating layer is configured to extend to contact the upper surface of the semiconductor substrate and to contact respective side surfaces of each of the planar gate electrode layers.

12. The power semiconductor device of claim 10, or 11, further comprising:
a bottom insulating layer disposed under the trench gate electrode layers and the intermediate insulating layer and configured to contact the intermediate insulating layer.

13. The power semiconductor device of claim 12, wherein the bottom insulating layer is configured to extend along respective side surfaces of each of the trench gate electrode layers and to extend over the upper surface of the semiconductor substrate, and
wherein the top insulating layer is configured to contact the bottom insulating layer on the upper surface of the semiconductor substrate.

14. The power semiconductor device of any one of claims 10 to 13, further comprising:
a source electrode layer disposed on the top insulating layer and configured to contact a side surface of the top insulating layer; and
a drain electrode layer disposed under a lower surface of the semiconductor substrate and configured to face the upper surface of the semiconductor substrate.

15. The power semiconductor device of any one of claims 8 to 14, further comprising:
a source region disposed inside the semiconductor substrate, configured to overlap each of the planar gate electrode layers, and comprising an impurity of a first conductive type; and
a body region configured to contact a lower surface of the source region and comprising an impurity of a second conductive type, the second conductive type being opposite to the first conductive type.
